Europäisches Patentamt

European Patent Office

Office européen des brevets

(11) Publication number: **0 521 527 A2**

# EUROPEAN PATENT APPLICATION

(21) Application number: **92111361.9**

(22) Date of filing: **03.07.92**

(51) Int. Cl.⁵: **G01R 33/032**

A request for correction in the description and claims has been filed pursuant to Rule 88 EPC. A decision on the request will be taken during the proceedings before the Examining Division (Guidelines for Examination in the EPO, A-V, 2.2).

(30) Priority: **05.07.91 JP 191193/91**

(43) Date of publication of application:
**07.01.93 Bulletin 93/01**

(84) Designated Contracting States:
**DE FR GB IT**

(71) Applicant: **MITSUBISHI GAS CHEMICAL COMPANY, INC.**
**5-2, Marunouchi 2-chome Chiyoda-Ku Tokyo, 100(JP)**

(72) Inventor: **Shirai, Kazushi, c/o Mitsubishi Gas Chem. Co. Inc**
**Tokyo Laboratory, 1-1, Niijuku 5-chome Katsushika-ku, Tokyo 125(JP)**
Inventor: **Shinbo, Toshihiro, Mitsubishi Gas Chem. Co. Inc.**
**Tokyo Laboratory, 1-1, Niijuku 5-chome Katsushika-ku, Tokyo 125(JP)**
Inventor: **Takeda, Norio, Mitsubishi Gas Chem. Co., Inc.**
**Tokyo Laboratory, 1-1, Niijuku 5-chome Katsushika-ku, Tokyo 125(JP)**
Inventor: **Arii, Mitsuzo, Mitsubishi Gas Chem. Co., Inc.**
**Tokyo Laboratory, 1-1, Niijuku 5-chome Katsushika-ku, Tokyo 125(JP)**

(74) Representative: **Pfenning, Meinig & Partner Mozartstrasse 17 W-8000 München 2(DE)**

(54) **Magnetic garnet single crystal for measuring magnetic field intensity and optical type magnetic field intensity measuring apparatus.**

㊼ A bismuth substituted magnetic garnet has an extremely small temperature dependence of sensitivity to a light having a wavelength of 790-860 nanometers. The garnet has a compound suitable for a Faraday rotator and is given by

$$Ho_XTb_YBi_{3-X}Fe_{5-Z}A_ZO_{12}$$

where A is at least one of groups of Ga, Al, Sc, and In, and $0 \leq Y/X \leq 1.0$, $1.5 \leq X + Y \leq 1.9$, and $0 \leq Z \leq 0.4$.

EP 0 521 527 A2

## BACKGROUND OF THE INVENTION

### Field of the Invention

The present invention relates to a magnetic garnet single crystal used for measuring a magnetic field and used in a magneto-optical measuring apparatus based on the magneto-optical effect of the magnetic garnet single crystal. The magnetic garnet single crystal is a material whose sensitivity to light exhibits an extremely low temperature dependence at wavelengths of the light ranging from 790 to 860 nanometers and which is suitable for a Faraday rotator. The compound of such a magnetic garnet crystal is given by

$$Ho_XTb_YBi_{3-X-Y}Fe_{5-Z}A_ZO_{12}$$

where A is at least one selected from among Ga, Al, Sc, and In, and $0 \leq Y/X \leq 1.0$, $1.5 \leq X+Y \leq 1.9$, and $0 \leq Z \leq 0.4$.

### Prior Art

It is well known that when a light is transmitted through a magneto-optical material having a good light transmissivity placed in a magnetic field and the light travels in the same direction as the magnetic field, the magneto-optical material causes the polarization plane of the light to rotate due to Faraday effect (O. Kamada et al., J.Magn.Soc.Jpn., Vol. 11, Supplement. No.S1(1987)401-404). Specifically, such a rotation occurs while a light is traveling through, for example, lead glass. The magnitude of rotation of polarization plane or Faraday rotation $\theta$ in degrees is given by equation (1) as follows:

$$\theta = V\ Hex\ L \qquad (1)$$

where V is Verdet constant(deg/Oe•cm), Hex is a magnetic field intensity(Oe), and L is the length(cm) of the magneto-optical material or element. Equation (1) shows that the intensity of a magnetic field where a magneto-optical material is placed can be determined by measuring the Faraday rotation $\theta$ of polarization plane of the light transmitted through the magneto-optical material. In other words, use can be made of the Faraday effect of magneto-optical materials such as paramagnetic glass for simple measurement of magnetic field intensity.

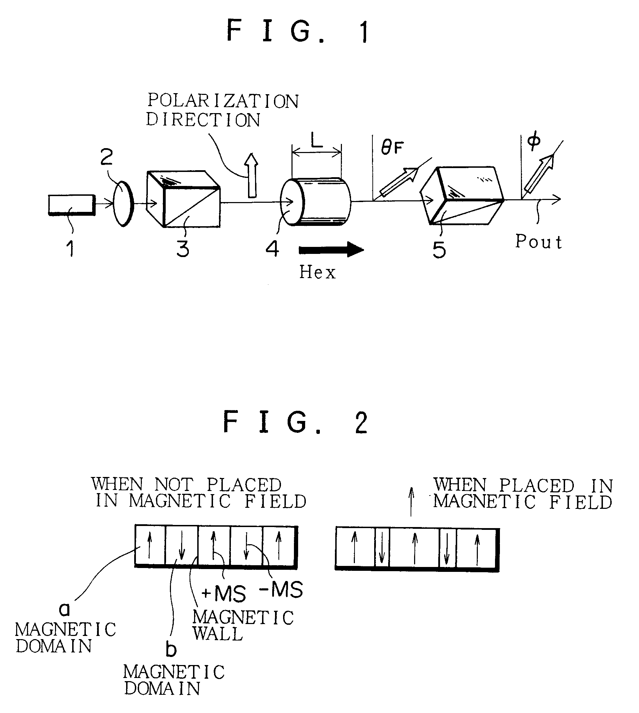

Fig. 1 shows a general arrangement of a magnetic field intensity measuring apparatus based on magneto-optical effect. In the figure, a light emitted from a light source 1 such as a semiconductor laser is condensed or is formed into a parallel light by a lens 2 such as a gradient index rod lens, and is then directed to a magnetic field intensity measuring apparatus. The emitted light enters a polarizer 3 such as calcite which converts the light therethrough into a linearly polarized light where the polarization plane is aligned in one direction. Then, the linearly polarized light enters a magneto-optical material e.g., a Faraday rotator 4 which causes the polarization plane of the light therethrough to rotate through an angle $\theta_F$ in accordance with the intensity of the magnetic field Hex. The light output of the Faraday rotator 4 is then transmitted through an analyzer 5 such as a polarizing cube beam splitter.

Magnetic field intensity may be measured in two methods; one is the extinction method where the analyzer 5 is rotated and the other is the fixed analyzer method where the analyzer 5 is fixed(The Transactions of the Institute of Electronics, Information and Communication Engineers MR89-53-(1990)55-61.) When an analyzer is rotated to face in a specific direction with respect to a light, the analyzer has a special effect called extinction where no linearly polarized light is permitted to go through the analyzer. The direction of the analyzer relative to the light 5 where extinction occurs, varies depending on the Faraday rotation $\theta_F$ of the Faraday rotator.

In the extinction method, the analyzer 5 is rotated to measure the variations of $\theta_F$ with respect to the angle through which the analyzer is rotated. Then, magnetic field Hex may be calculated by the use of equation (1) since the Faraday rotation $\theta_F$ is directly measured.

In the fixed analyzer method, the magnitude of Faraday rotation $\theta_F$ is converted by the analyzer 5 into a light output $P_{out}$ having an intensity in accordance with $\theta_F$. Assuming that the analyzer 5 is at an angle $\phi$ with respect to the polarizer 3, the light output $P_{out}$ is given by equation (2) as follows:

$$P_{out} = k \times \cos^2(\theta_F - \phi) \qquad (2)$$

where k is a proportional constant. Thus, equation (3) is derived from equations (1) and (2) as follows:

$$P_{out} = k \times \cos^2[V \bullet Hex \bullet L - \phi] \qquad (3)$$

Equation (3) indicates that the measurement of $P_{out}$ with the analyzer 5 fixed in position gives the magnitude of Hex, i.e., measurement of magnetic field intensity is possible.

The extinction method allows direct measurement of Faraday rotation and is not affected by the variations in intensity of the light emitted from a light source, offering high measurement accuracy. However, the apparatus is of rather high complexity in the extinction method. Thus, the fixed method is more common in magneto-optical measurement.

Paramagnetic glass and $Bi_{12}SiO_{20}$ (also referred to as BSO single crystal) are preferably used as materials for Faraday rotator used in magneto-optical measurement. However, these paramagnetic materials or diamagnetic materials provide not so high Faraday signal for unit magnetic field strength, i.e., low in sensitivity. Accordingly, it is difficult to implement miniaturized apparatuses as well as to provide good accuracy in measuring weak magnetic field intensity.

Recently, a thin film bismuth substituted rare-earth iron garnet single crystal used as a Faraday element for an optical isolator has been proposed as a new Faraday rotator for magneto-optical measurement(O. Kamada et al., J.Magn.Soc.Jpn., Vol.11, Supplement. No.S1(1987)401-404.) The thin film bismuth substituted rare-earth iron garnet single crystal has a sensitivity more than a hundred times as high as that of conventional paramagnetic glass and $Bi_{12}SiO_{20}$ single crystals. This new material is considered to be useful.

Bismuth substituted magnetic garnet is a ferromagnetic material and undergoes a magnetization process completely different from that of paramagnetic materials such as paramagnetic glass and $Bi_{12}SiO_{20}$ single crystal or diamagnetic materials (J.A.Pistorus et al. PHILIPS TECHNICAL REVIEW, 35(1975)1.) This process is specifically discussed by way of the thin film of magnetic garnet single crystal grown through the liquid-phase epitaxial method on a non-magnetic garnet substrate having a crystal orientation of (111) such as $Gd_3Ga_5O_{12}$.

Fig. 2 shows magnetic domains of a bismuth substituted magnetic garnet single crystal. The film of a magnetic garnet single crystal is magnetized in the direction normal to the film surface when the film is not placed in a magnetic field as shown in Fig. 2. Moreover, the film has two opposite directions of magnetization; one is directed to the film surface from the substrate and the other is directed away from the film surface. A magnetic material is made up of a number of parts which have magnetization directions different from each other. Each part of the magnetic material is referred to as a magnetic domain. The magnetic domains have widths different from each other according to the compound and/or the thickness of the film of magnetic garnet single crystal, ranging from two to ten $\mu$m. The magnetic domains are separated from each other by extremely small boundaries referred to as magnetic wall. For example, magnetic domain a has a Faraday rotation $+\theta_F$ and a intensity $+Ms$ of magnetization while magnetic domain b has $-\theta_F$ and $-Ms$. These values are nearly constant regardless of the intensity of a magnetic field where the material is placed. Ferromagnetic materials are said to have a multidomain structure since they are made up of a large number of magnetic domains.

If a ferromagnetic material having a large number of magnetic domains is placed in a magnetic field with a magnetic domain a oriented its magnetization $+Ms$ in the same direction as the magnetic field, then the magnetic wall moves toward a magnetic domain b so that the volume of the magnetic domain $\bar{b}$ grows smaller and smaller while at the same time the volume of the magnetic domain a increases larger and larger. When the magnetic field intensity reaches a certain value, the magnetic domain b completely disappears so that the magnetization of all of the other magnetic domains are oriented in the same direction. Then, the ferromagnetic material is said to be saturated. With the ferromagnetic material saturated, Faraday rotation may be measured. Paramagnetic materials not placed in a magnetic field have no magnetic domain as opposed to ferromagnetic materials. Paramagnetic materials are magnetized in accordance with a magnetic field intensity only when they are placed in that magnetic field. Thus, the paramagnetic materials have a single domain and are referred to as single domain material.

As mentioned above, ferromagnetic materials and paramagnetic materials are magnetized through completely different processes from each other. Thus, these two different materials exhibit some different phenomenon when they are used as a Faraday rotator. For example, when a light is transmitted through a multidomain material as shown in Fig. 2, the magnetic domains become phase lattices which cause the light to be diffracted [T. R. Johansen et al. J.Appl.Phys., 42(1971) 1715.] The diffracted light has a plane of polarization completely different from that of a non-diffracted light. Thus, diffracted light rays leaking into the light indicative of Faraday rotation causes poor accuracy in measuring Faraday rotation(Japanese Patent Preliminary Publication No.63-163815.) Therefore, a measure is essential which prevents poor accuracy in measuring Faraday rotation due to diffraction caused by magnetic domains. In other words, unwanted detection of a diffracted light should be prevented by, for example, providing pin holes in the light path.

Tanazawa et al. reported that equations (1) and (2) fundamental in magnetic field measurement, will not be satisfied in ferromagnetic materials- [Tanazawa et al. Denshi Tsushin Gakkai Technical Report MR89-53, 1990.]

In other words, in Fig. 1, a non-diffracted light is given by equation (4) assuming the proportional constant k equal to 1.

$$P_{out} = [\cos\phi \times \cos\theta_F + (M/Ms) \times \sin\phi \times \sin\theta_F]^2 \quad (4)$$

where M is a apparent magnetization of the whole material. We have the following relation in connection with Fig. 2.

$$M = [(p - q)/(p + q)] \times Ms \qquad (5)$$

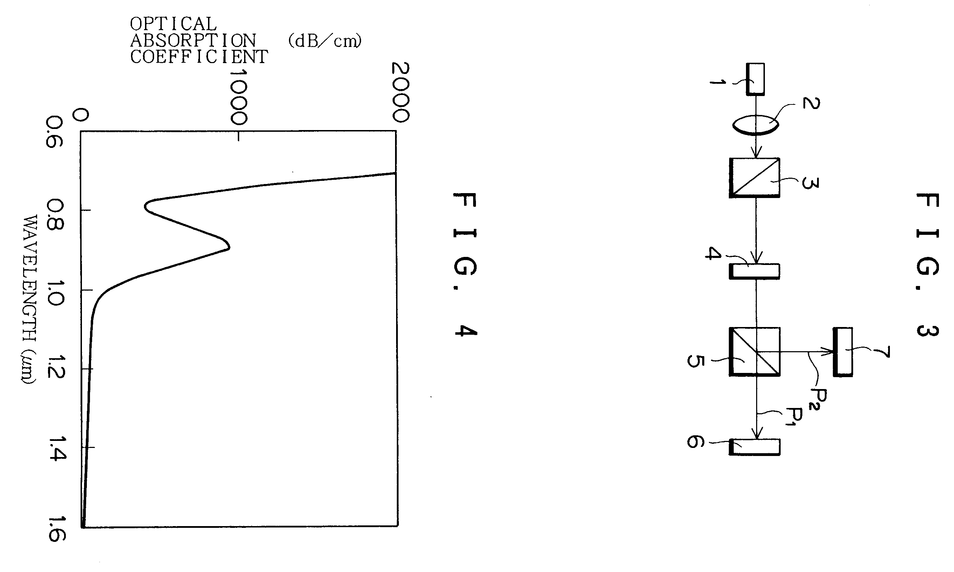

where p is the volume of a magnetic domain a and q is the volume of a magnetic b. Equations (4) and (5) indicate that the change in volume of the magnetic domains a and b in Fig. 2 or the change in apparent magnetization of the whole material. Fig. 3 shows a general arrangement of the double-ended differential fixed analyzer method. Tanazawa et al. also reported that the arrangement in Fig. 3 enables complete removal of adverse effects of diffracted light rays entering the measurement of Faraday rotation (Tanazawa et al. Denshi Tsushin Gakkai Technical Report MR89-53, 1990.) That is, the arrangement in Fig. 3 is the same as that of Fig. 1 in that a light enters the analyzer 5, but is different in that light output is split by an analyzer such as a polarization splitter into two beams whose polarization planes are perpendicular to each other. The two beams are measured their intensities P1 and P2 with power meters 6 and 7, respectively. Then, the difference(P1-P2) in intensity between the two beams is used as a Faraday signal. This method is referred to as double-ended differential fixed analyzer method. Meanwhile, single-ended differential fixed analyzer method is a method where the intensity of only one of the beams through the analyzer 5 is measured. In the double-ended differential fixed analyzer method, the light intensity P1 is directly given by Eq(4) and the light intensity P2 is given by putting ($\phi + \pi/2$) instead of putting $\phi$ into Eq(4). For example, a light intensity $P_{out}$ for $\phi = \pi/4$ is given as follows:

$$P_{out} = (M/Ms) \times \sin(2\theta_F) \qquad (6)$$

As is described above, when used as a Faraday rotator in magneto-optical measurement, paramagnetic materials and ferromagnetic materials exhibit completely different relations between light output and magnetic field where the Faraday rotator is placed.

In reality, the most important property of a Faraday rotator is the temperature dependence of sensitivity. That is, a measurement apparatus is in demand whose sensitivity is temperature independent, i.e., the light output is immune to changes in ambient temperature. Commercially available bismuth substituted magnetic garnet single crystals suffer from a serious problem that the sensitivity is highly temperature dependent. For this reason, magnetic field measuring apparatuses having high sensitivity have not yet been put into a practical use.

In order to use paramagnetic materials such as paramagnetic glass and diamagnetic materials such as $Bi_{12}SiO_{20}$ single crystal as a Faraday rotator, the material should have minimum temperature dependence of Verdet constant V to control the temperature dependence of intensity of a light output[National Technical report Vol.29 No.7, 716-726(1983).] This is because the temperature dependence of intensity of a light output $P_{out}$ depends only on the temperature dependence of Verdet constant V.

For ferromagnetic materials, strictly speaking, Verdet constant V cannot be defined since the magnetization saturates. Thus, sensitivity constant is defined in terms of the ratio($\theta_F$/Ms) of Faraday rotation $\theta_F$ when the magnetization is saturated[O.Kamada et al. J.Mgn.Soc.Jpn., Vol.11, Supplement. No.S1(1987)401-404.]

Ferromagnetic materials to be used as a Faraday rotator should have sensitivity of minimum temperature dependence, which sensitivity corresponds to Verdet constant V. Many researchers have been working to develop materials having minimum temperature dependence. Up to the present, ferromagnetic materials having sufficiently small temperature dependence, i.e., bismuth substituted magnetic garnet single crystals have not been developed yet. The major reasons for this are as follows:

(1) Many factors influence the temperature dependence of sensitivity.
(2) The relations between the factors and sensitivity are complex.

Thin film of bismuth substituted magnetic garnet single crystal has been proposed as a new Faraday rotator that replaces paramagnetic glass and $Bi_{12}SiO_{20}$ which have been commonly used. However, the thin film bismuth substituted magnetic garnet single crystal still has a serious deficiency that sensitivity highly depends on temperature variations.

Honda et al. have proposed $(EuHoBi)_3Fe_5O_{12}$ and $(YHoBi)_3Fe_5O_{12}$ as materials having small temperature dependence of sensitivity (Japanese Patent Preliminary Publication No.3-8724, No.2-196100.) However, the sensitivity cannot be accurately defined in terms of the ratio($\theta_F$/Ms) of saturated magnetization Ms to the Faraday rotation $\theta_F$ when the magnetization is saturated. Thus, a material cannot be said to have a sensitivity of a small temperature dependence just because the material has a sensitivity constant($\theta_F$/Ms) of a small temperature dependence. In other words, sensitivity constant cannot be a criterion for evaluating a thin film bismuth substituted magnetic garnet single crystal used for magneto-optical measurement.

Ishikawa et al. have proposed a method using two light sources having different wavelengths-

[Proceedings of 14th Annual Conference of Magnetic Society of Japan 8pH-15, 1990.] In Ishikawa et al. method, a light output is measured by the use of two light beams having different wavelengths, and the temperature dependence of sensitivity is canceled out by taking the difference between the two light outputs so as to improve the overall temperature dependence. $(GdBi)_3(FeAlGa)_5O_{12}$ single crystal of a thickness of 198 $\mu m$ is used to measure light output from a light sources having wavelengths of 1.31 $\mu m$ and 0.83 $\mu m$, respectively, through single-ended differential fixed analyzer method. The resultant rate of change of sensitivity is ±2% for temperatures ranging from 20 to 45 degrees Celsius. However, Ishikawa et al. method requires two light sources and two detectors, necessitating complex optical paths and increased number of parts. This is uneconomical.

A bismuth substituted magnetic garnet single crystal has a feature of high sensitivity while also having a drawback that sensitivity is highly temperature dependent. This is why this material has not yet been put into practical use as a Faraday rotator for magneto-optical measurement.

SUMMARY OF THE INVENTION

The inventors of the present invention noted the high sensitivity of a bismuth substituted magnetic garnet single crystal, and carried out fundamental research about the compounds and their physical quantities, particularly temperature dependence of sensitivity. Then, the inventors acquired knowledge that a specific bismuth substituted rare-earth iron magnetic garnet has a small temperature dependence of sensitivity, and further research work led the inventors to achieve the present invention.

An object of the present invention is to provide, on an industrial scale, a bismuth substituted rare-earth iron magnetic garnet single crystal for industrial use having a very small temperature dependence of sensitivity, i.e., Faraday rotator for magneto-optical measurement.

The inventors made various bismuth substituted rare-iron magnetic garnet single crystals to evaluate properties when used as a Faraday rotator for magneto-optical measurement. The inventors noted that preferable properties are obtained from magnetic garnet single crystals, particularly those whose rare-earth iron elements are holmium Ho or both holmium and terbium Tb, whose compounds are given by $Ho_XTb_YBi_{3-X-Y}Fe_{5-Z}A_ZO_{12}$ where A is at least one selected from among Ga, Al, Sc, and In which are trivalent non-magnetic ions, and $0 \leq Y/X \leq 1.0$, $1.5 \leq X+Y \leq 1.9$, $0 \leq Z < 0.4$. These single crystals have very small changes in sensitivity with temperature. The optical absorption coefficient $\alpha$ (dB/cm) of bismuth substituted magnetic garnet influences the sensitivity as much as or more greatly than other factors such as apparent magnetization M of the whole material, intensity of saturated magnetization Ms, and Faraday rotation $\theta_F$. By putting an optical absorption coefficient $\alpha$ of Faraday rotation $\theta_F$ into Eq(3), we obtain

$$P_{out} = \exp(-\alpha \cdot d)[\cos\phi \ X \cos \theta_F \ + \ (M/Ms) \ X \sin\phi \ X \sin\theta_F]^2 \qquad (7)$$

where d is the thickness of a material.

Fig. 4 shows spectra of optical absorption of a magnetic garnet. The optical absorption of, for example, paramagnetic glass and $Bi_{12}SiO_{20}$ is very small, and therefore is assumed to have only a small effect on the temperature dependence of sensitivity. However, the optical absorption of bismuth substituted magnetic garnet is very large in the range from visible lights to near infrared radiation. This optical absorption is due to iron $Fe^{3+}$ as shown in Fig. 4. Fig. 5 shows temperature versus change in optical absorption. In Fig. 5, the temperature dependence of optical absorption of bismuth substituted magnetic garnet (in 0.8$\mu m$ band) is too large to ignore.

From Eq(7), light output $P_{out}$ depends on the temperature dependence of variables $\alpha$, M, Ms, and $\theta_F$. Each variable influences the light output according to the thickness d of material and the angle $\phi$ of polarizer with respect to the analyzer. More specifically, for the same temperature, the measurement of light output $P_{out}$ differs for a bismuth substituted magnetic garnet having a thickness of d1 and a Faraday rotation $\theta_{F1}$, and a bismuth substituted magnetic garnet having a thickness of d2 and a Faraday rotation $\theta_{F2}$. The light output may also vary according to the angles $\phi$ of principal axis of polarizer with respect to that of analyzer.

The optical absorption coefficient $\alpha$ greatly varies according to wavelength. Accordingly, the accurate measurement of light output requires not only optimum thickness d of material and optimum angle $\phi$ of polarizer with respect to the analyzer but also the optimum wavelength $\lambda$ of light. The inventors performed various experiments and investigated the results of the experiments in terms of the angle $\phi$ of the principal axis of polarizer with respect to that of analyzer. The experiments revealed that the temperature dependence of sensitivity becomes dependent on the magnetic field when the angle deviates from an optimum value, i.e., 45 degrees referred to as dependence of sensitivity on magnetic field. The effects of a magnetic field on sensitivity may be ignored for angles $\phi$ in the range of 45±3 degrees.

The accuracy of measurement of light output decreases for angles outside this range.

The wavelengths of light sources for magneto-optical measuring apparatuses are determined taking into consideration factors such as sensitivity of a Faraday rotator, transmittance, the performance and price of a light source, and the sensitivity of a detector. The wavelength of a light source in the present invention is near-infrared-radiation preferably in the range of 790-860 nm for the following reasons.

(1) A bismuth substituted magnetic garnet has a range called a "window" where an optical absorption coefficient is relatively small.

(2) A bismuth substituted magnetic garnet shows larger Faraday rotation coefficients-(deg/cm,) which is a Faraday rotation per unit thickness.

(3) a bismuth substituted magnetic garnet has film thicknesses in the range of 50-100 $\mu$m which is easy to manufacture.

(4) Semiconductor lasers and light emitting diodes are commercially available at low prices which provide high power and short wavelength.

(5) Photoreceptors show high sensitivities and are available at low costs.

Wavelengths outside 790-860 nm range cause inaccurate measurement of light output $P_{out}$.

When reducing the present invention, a Faraday rotator or a bismuth substituted magnetic garnet may be selected from among magnetic garnet single crystals given by

$$Ho_XTb_YBi_{3-X-Y}Fe_{5-Z}A_ZO_{12}$$

where A is at least one selected from among Ga, Al, Sc, and In, and $0 \leqq Y/X \leqq 1.0$, $1.5 \leqq X+Y \leqq 1.9$, and $0 \leqq Z \leqq 0.4$.

The bismuth substituted magnetic garnet may be preferably selected in connection with the wavelength of a light source as follows:

(1) For wavelengths of 800±10 nm,

$$Ho_XTb_YBi_{3-X-Y}Fe_{5-Z}A_ZO_{12}$$

where A is at least one of groups of Ga, Al, Sc, and In, and $0 \leqq Y/X \leqq 0.5$, $1.5 \leqq X+Y \leqq 1.8$, and $0 \leqq Z \leqq 0.4$.

(2) For wavelengths of 820±10 nm,

$$Ho_XTb_YBi_{3-X-Y}Fe_{5-Z}A_ZO_{12}$$

where A is at least one of groups of Ga, Al, Sc, and In, and $0 \leqq Y/X \leqq 0.8$, $1.5 \leqq X+Y \leqq 1.8$, and $0 \leqq Z \leqq 0.4$.

(3) For wavelengths of 845±10 nm,

$$Ho_XTb_YBi_{3-X-Y}Fe_{5-Z}A_ZO_{12}$$

where A is at least one of groups of Ga, Al, Sc, and In, and $0 \leqq Y/X \leqq 1.0$, $1.5 \leqq X+Y \leqq 1.9$, and $0 \leqq Z \leqq 0.4$.

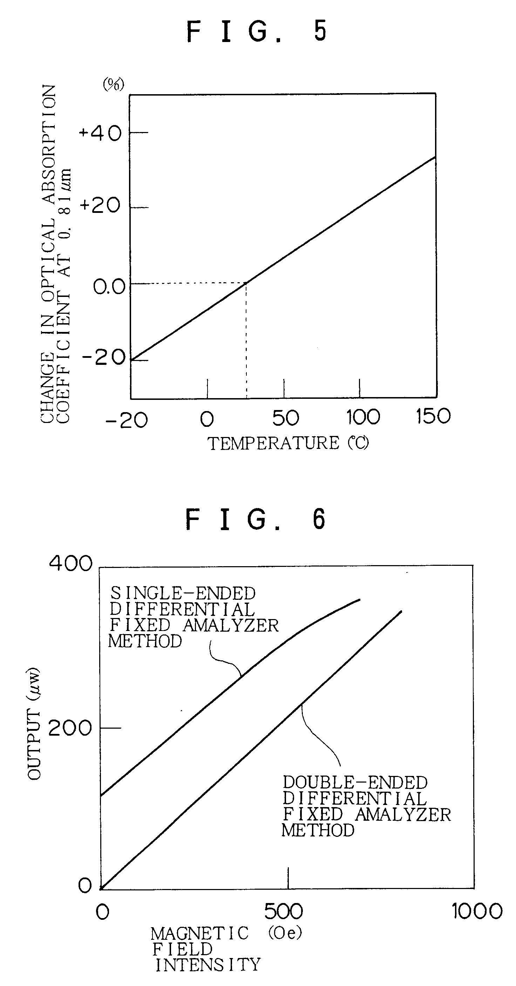

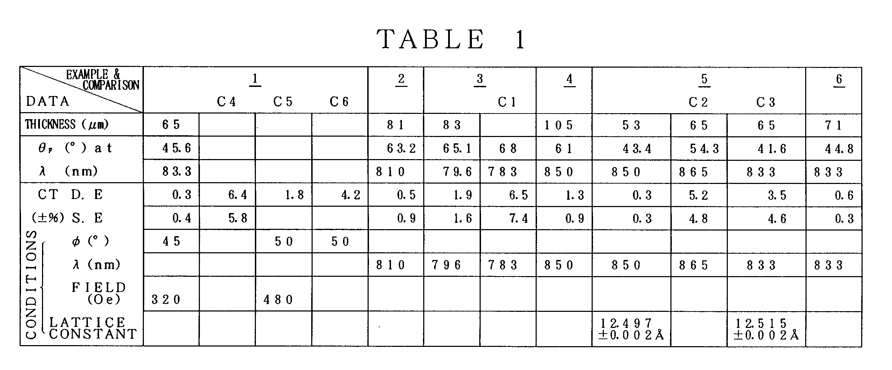

Fig. 6 shows a magnetic field versus light output. As shown in Fig. 6, in the present invention, light output $P_{out}$ shows a good linearity over a wide range of the magnetic field Hex where the Faraday rotator is placed. This indicates that both the double-ended differential fixed analyzer method and single-ended differential fixed analyzer method are equally applicable in the invention. The two methods may be selected according to, for example, what range of a magnetic field is to be measured. For measuring magnetic field intensity in a relatively narrow range, the single-ended differential fixed method which is simple in construction may conveniently be used.

A bismuth substituted magnetic garnet single crystal according to the invention may be manufactured through any known manufacturing process. However, liquid phase epitaxial(LPE) method-(W.Tolksdorf et al. Thin Solid Films 114(1984)33) is preferably used which is very suitable for quantity production. In the liquid phase epitaxial method, a substrate of any known type may be used. A commercially available garnet single crystal $(GdCa)_3(GaMgZr)_5O_{12}$ may be used which is referred to as SGGG substrate and has lattice constants in the range of 12.490-12.515 angstroms.

The invention makes it possible to accurately measure a magnetic field, particularly a weak magnetic field, without influences from ambient temperatures, and to implement miniaturized magnetic field measuring apparatuses. Embodiments and their advantages will be described by way of examples. The examples are only exemplary and will not limit the scope or manners in which the invention is applied to related apparatuses.

BRIEF DESCRIPTION OF THE PREFERRED EMBODIMENTS

Features and other objects of the invention will be more apparent from the description of the preferred examples with reference to the accompanying drawings in which:

Fig. 1 shows the principle of magneto-optical measurement;

Fig. 2 shows magnetic domains of a bismuth substituted magnetic garnet single crystal;

Fig. 3 shows a general arrangement of the double-ended differential fixed analyzer method;

Fig. 4 shows spectra of optical absorption of a magnetic garnet;

Fig. 5 shows temperature versus change in optical absorption;

Fig. 6 shows a magnetic field versus light output; and

Table 1 shows the data of examples of the present invention and the data of comparisons.

PREFERRED EMBODIMENTS OF THE INVENTION

Example 1

Table 1 shows the data of examples of the present invention and the data of comparisons. A 500 ml platinum crucible was placed on an LPE furnace, which platinum crucible contains therein lead oxide(PbO, 4N) of 843 grams, bismuth oxide-($Bi_2O_3$, 4N) of 978 grams, ferric oxide($Fe_2O_3$, 4N) of 128 grams, boron oxide($B_2O_3$, 5N) of 38 grams, terbium oxide($Tb_4O_7$, 3N) of 4.0 grams, and holmium oxide($Ho_2O_3$, 3N) of 9.0 grams. The content of the crucible was heated to a temperature of 1000 degrees to melt. The melted content was sufficiently beaten for uniform mixture and was then cooled down to a melt temperature of 772 degrees to produce a melt for growing a bismuth substituted magnetic garnet single crystal.

Then, a substrate of a garnet single crystal $(GdCa)_3(GaMgZr)_5O_{12}$ having a lattice constant of 12.497±0.002 angstroms was placed using a known procedure on the surface of the thus produced melt for 2.5 hours for epitaxial growth while maintaining the melt temperature at 772 degrees. A crystal obtained was a bismuth substituted magnetic garnet single crystal having a compound of $Ho_{1.1}Tb_{0.6}Bi_{1.3}Fe_5O_{12}$ and having a film thickness of 65 $\mu$m. This crystal showed a Faraday rotation $\theta$F of 45.6 degrees at a wavelength 833 nm with magnetization saturated.

Then, the temperature dependence of sensitivity was measured both in the double-ended differential fixed analyzer method and in the single-ended differential fixed analyzer method. In this measurement, a light source 1 was a semiconductor laser having a wavelength of 833 nm and a lens 2 was a gradient index rod lens that converts the laser light into parallel rays. A polarizer 3 was a Glan-Thompson prism and an analyzer 5 was a polarizing cube beam splitter. The Glan-Thompson prism 3 and the polarized beam splitter 5 were positioned such that they made an angle of 45 degrees with respect to each other, and the diameter of the beam was two millimeters. In the single-ended differential fixed analyzer method, in order to eliminate the influence of a diffracted light, a 5-mm diameter pin hole board(usually referred to as "pin-hole" which was coined by the manufacturer, Fujikoki) was placed in the center of the optical path.

Then, a sample of bismuth substituted magnetic garnet single crystal was placed in position within the heat transferring device made of aluminum. Light output was measured for temperatures(the temperature of a chamber where the sample is placed) in the range of from -20 to +80 degrees with a magnetic field of 320 Oe applied. A known procedure of calculation revealed that the change(CT%) in sensitivity with temperature was ±0.3% for the double-ended differential fixed analyzer method and ±0.4% for the single-ended differential fixed analyzer method.

Example 2

In a similar manner to Example 1, a single crystal obtained was $Ho_{1.1}Tb_{0.6}Bi_{1.3}Fe_5O_{12}$ having a film thickness of 81 $\mu$m.
This single crystal showed a Faraday rotation $\theta$F of 63.2 degrees at a wavelength 810 nm. In Example 2, the measurement conditions were the same as in Example 1 except that a semiconductor laser of a wavelength of 810 nm was used instead of a semiconductor laser of a wavelength of 833 nm. A calculation similar to Example 1 revealed that the change(CT%) in sensitivity with temperature was ±0.5% for the double-ended differential fixed analyzer method and ±0.9% for the single-ended differential fixed analyzer method.

Example 3

In a similar manner to Example 1, a single crystal obtained was $Ho_{1.1}Tb_{0.6}Bi_{1.3}Fe_5O_{12}$ of a film thickness of 83 $\mu$m.
This single crystal showed a Faraday rotation $\theta$F of 65.1 degrees at a wavelength of 796 nm. In Example 3, the measurement conditions were the same as in Example 1 except that a semiconductor laser of a wavelength of 796 nm was used in place of a wavelength 833 nm. A calculation similar to Example 1 revealed that the change(CT%) in sensitivity with temperature was ±1.9% for the double-ended differential fixed analyzer method and ±1.6% for the single-ended differential fixed analyzer method.

Example 4

A single crystal of $Ho_{0.95}Tb_{0.95}Bi_{1.1}Fe_5O_{12}$ having a film thickness of 105 $\mu$m was obtained in a similar manner to Example 1 except that terbium oxide($Tb_4O_7$, 3N) of 6.5 grams and holmium oxide-($Ho_2O_3$, 3N) of 6.5 grams are used in place of terbium oxide ($Tb_4O_7$, 3N) of 4.0 grams and holmium oxide($Ho_2O_3$, 3N) of 9.0 grams.
This single crystal showed a Faraday rotation $\theta$F of 61.0 degrees at a wavelength of 850 nm. In Example 3, the measurement conditions are the same as in Example 1 except that a semiconductor laser of a wavelength of 850 nm was used in place of a wavelength 833 nm. A calculation similar to Example 1 revealed that the change(CT%) in sensitivity with temperature was ±1.3% for the double-ended differential fixed analyzer method and ±0.9% for the single-ended differential fixed analyzer method.

## Example 5

A single crystal of $Ho_{1.5}Bi_{1.5}Fe_5O_{12}$ having a film thickness of 53 $\mu$m was obtained in a similar manner to Example 1 except that holmium oxide-($Ho_2O_3$, 3N) of 13.0 grams was used in place of terbium oxide($Tb_4O_7$, 3N) of 4.0 grams and holmium oxide($Ho_2O_3$, 3N) of 9.0 grams.
This single crystal showed a Faraday rotation $\theta$F of 43.4 degrees at a wavelength 850 nm. In Example 5, the measurement conditions were the same as in Example 1 except that a semiconductor laser of a wavelength of 850 nm was used in place of a wavelength 833 nm. A calculation similar to Example 1 revealed that the change(CT%) in sensitivity with temperature was ±0.3% for the double-ended differential fixed analyzer method and ±0.3% for the single-ended differential fixed analyzer method.

## Example 6

A single crystal of $Ho_{1.1}Tb_{0.6}Bi_{1.3}Fe_{4.7}Ga_{0.3}O_{12}$ having a film thickness of 71 $\mu$m was obtained in a similar manner to Example 1 except that gallium oxide($Ga_2O_3$, 4N) of 4.8 grams is added to the melt of Example 1.
This single crystal showed a Faraday rotation $\theta$F of 44.8 degrees at a wavelength of 833 nm. In Example 6, the measurement conditions are exactly the same as in Example 1. A calculation similar to Example 1 revealed that the change(CT%) in sensitivity with temperature was ±0.6% for the double-ended differential fixed analyzer method and ±0.3% for the single-ended differential fixed analyzer method.

## Comparison 1

The change(CT%) in sensitivity with temperature of Example 3 was determined in the same manner as in Example 3 except that a semiconductor laser having a wavelength of 783 nm is used instead of a wavelength of 796 nm. The change-(CT%) in sensitivity with temperature was ±6.5% for the double-ended differential fixed analyzer method and ±7.4% for the single-ended differential fixed analyzer method.
The single crystal showed a Faraday rotation $\theta$F of 68.0 degrees at a wavelength of 783 nm. Comparison 1 shows that wavelengths outside the range of 790-860 nm cause CT% to increase.

## Comparison 2

A single crystal of $Ho_{1.5}Bi_{1.5}Fe_5O_{12}$ having a film thickness of 65 $\mu$m was obtained in the same manner as in Example 5. The single crystal showed a Faraday rotation $\theta$F of 54.3 degrees at a wavelength 865 nm. The change(CT%) in sensitivity with temperature was determined in the same manner as in Example 1 except that a semiconductor laser having a wavelength of 865 nm was used instead of a wavelength of 833 nm. The change-(CT%) in sensitivity with temperature was ±5.2% for the double-ended differential fixed analyzer method and ±4.8% for the single-ended differential fixed analyzer method. Comparison 1 shows that wavelengths outside the range of 790-860 nm cause CT% to increase.

## Comparison 3

A single crystal of $Ho_{1.4}Bi_{1.6}Fe_5O_{12}$ having a film thickness of 65 $\mu$m was obtained in the same manner as in Example 5 except that a substrate of garnet single crystal $[(GdCa)_3(GaMgZr)_5O_{12}]$ having a lattice constant of 12.515±0.002 angstroms instead of a substrate of garnet single crystal $[(GdCa)_3(GaMgZr)_5O_{12}]$ having a lattice constant of 12.497±0.002 angstroms. The single crystal showed a Faraday rotation $\theta$F of 41.6 degrees at a wavelength 833 nm. The change(CT%) in sensitivity with temperature was determined in the same manner as in Example 1. The change(CT%) in sensitivity with temperature was ±3.5% for the double-ended differential fixed analyzer method and ±4.6% for the single-ended differential fixed analyzer method. Comparison 3 shows that a change in lattice constant causes an increase of CT%.

## Comparison 4

A single crystal of $Ho_{0.6}Tb_{1.4}Bi_{1.0}Fe_5O_{12}$ having a film thickness of 80 $\mu$m was obtained in the same manner as in Example 1 except that terbium oxide[$Tb_4O_7$, 3N] of 8.0 grams and holmium oxide-[$Ho_2O_3$, 3N] of 3.0 grams are used instead of terbium oxide[$Tb_4O_7$, 3N] of 4.0 grams and holmium oxide[$Ho_2O_3$, 3N] of 9.0 grams.
The single crystal showed a Faraday rotation $\theta$F of 47.2 degrees at a wavelength of 833 nm. The change(CT%) in sensitivity with temperature was determined in the same manner as in Example 1. The change(CT%) in sensitivity with temperature was ±6.4% for the double-ended differential fixed analyzer method and ±5.8% for the single-ended differential fixed analyzer method. Comparison 4 shows that different combinations in the quantity of terbium oxide and holmium oxide result in increases in CT%.

Comparison 5

The change(CT%) in sensitivity with temperature was determined in the same manner as in Example 1 except that the angle of the polarizer 3 with respect to the analyzer 5 was 50 degrees instead of 45 degrees and the magnetic field in which the single crystal was placed was 480 Oe instead of 320 Oe. The change(CT%) in sensitivity with temperature was ±1.8% for the double-ended differential fixed analyzer method. Comparison 5 shows that the deviation of angle $\phi$ from 45 degrees accounts for an increase of CT%.

Comparison 6

The change(CT%) in sensitivity with temperature was determined in the same manner as in Example 1 except that the angle of the polarizer 3 with respect to the analyzer 5 was 50 degrees instead of 45 degrees, and the magnetic field in which the crystal was placed was 320 Oe. The change(CT%) in sensitivity with temperature was ±4.2% for the double-ended differential fixed analyzer method.

**Claims**

1. A bismuth substituted magnetic garnet having an extremely small temperature dependence of sensitivity to a light having a wavelength of 790-860 nanometers, said garnet having a compound suitable for a Faraday rotator and given by

   $$Ho_X Tb_Y Bi_{3-X} Fe_{5-Z} A_Z O_{12}$$

   where A is at least one of groups of Ga, Al, Sc, and In, and $0 \leq Y/X \leq 1.0$, $1.5 \leq X+Y \leq 1.9$, and $0 \leq Z \leq 0.4$.

2. A bismuth substituted magnetic garnet having an extremely small temperature dependence of sensitivity to a light having a wavelength of 800±10 nanometers, said garnet having a compound suitable for a Faraday rotator and given by

   $$Ho_X Tb_Y Bi_{3-X} Fe_{5-Z} A_Z O_{12}$$

   where A is at least one of groups of Ga, Al, Sc, and In, and $0 \leq Y/X \leq 0.5$, $1.5 \leq X+Y \leq 1.8$, and $0 \leq Z \leq 0.4$.

3. A bismuth substituted magnetic garnet having an extremely small temperature dependence of sensitivity to a light having a wavelength of 820±10 nanometers, said garnet having a compound suitable for a Faraday rotator and given by

$$Ho_X Tb_Y Bi_{3-X} Fe_{5-Z} A_Z O_{12}$$

where A is at least one of groups of Ga, Al, Sc, and In, and $0 \leq Y/X \leq 0.8$, $1.5 \leq X+Y \leq 1.8$, and $0 \leq Z \leq 0.4$.

4. A bismuth substituted magnetic garnet having an extremely temperature dependence of sensitivity to a light having a wavelength of 845±15 nanometers, said garnet having a compound suitable for a Faraday rotator and given by

   $$Ho_X Tb_Y Bi_{3-X} Fe_{5-Z} A_Z O_{12}$$

   where A is at least one of groups of Ga, Al, Sc, and In, and $0 \leq Y/X \leq 1.0$, $1.5 \leq X+Y \leq 1.9$, and $0 \leq Z \leq 0.4$.

5. An optical type magnetic field intensity measuring apparatus comprising:

   a light source for outputting a light having a wavelength in the range of 790-860 nanometers;

   a polarizer for converting the light from said light source into a linearly polarized light having a polarization plane;

   a Faraday rotator 4 placed in a magnetic field for receiving said light through said polarizer so as to cause the polarization plane of the light to rotate in accordance with the intensity of said magnetic field, said Faraday rotator being a magnetic garnet single crystal having a compound given by

   $$Ho_X Tb_Y Bi_{3-X} Fe_{5-Z} A_Z O_{12}$$

   where A is at least one of groups of Ga, Al, Sc, and In, and $0 \leq Y/X \leq 1.0$, $1.5 \leq X+Y \leq 1.9$, and $0 \leq Z \leq 0.4$.
   ; and

   an analyzer for converting the magnitude of Faraday rotation into a light output having an intensity in accordance with said intensity of said magnetic field.

# F I G. 1

POLARIZATION
DIRECTION

2

$L$   $\theta F$   $\phi$

POLARIZATION DIRECTION

1   3   4   5   Pout

Hex

# F I G. 2

WHEN NOT PLACED
IN MAGNETIC FIELD

WHEN PLACED IN
MAGNETIC FIELD

+MS  −MS
MAGNETIC
WALL

a

MAGNETIC
DOMAIN

b

MAGNETIC
DOMAIN

# F I G.  3

# F I G.  4

# F I G. 5

CHANGE IN OPTICAL ABSORPTION COEFFICIENT AT 0.81 μm (%)

+40 +20 0.0 -20

TEMPERATURE (°C)

-20  0  50  100  150

# F I G. 6

400

OUTPUT (μw)

200

0

SINGLE-ENDED DIFFERENTIAL FIXED AMALYZER METHOD

DOUBLE-ENDED DIFFERENTIAL FIXED AMALYZER METHOD

0      500      1000

MAGNETIC (Oe) FIELD INTENSITY

# TABLE 1

| DATA \ EXAMPLE & COMPARISON | 1 | C4 | C5 | C6 | 2 | 3 | C1 | 4 | 5 | C2 | C3 | 6 |
|---|---|---|---|---|---|---|---|---|---|---|---|---|
| THICKNESS ($\mu$m) | 6 5 | | | | 8 1 | 8 3 | | 1 0 5 | 5 3 | 6 5 | 6 5 | 7 1 |
| $\theta_F$ (°) at | 4 5.6 | | | | 6 3.2 | 6 5.1 | 6 8 | 6 1 | 4 3.4 | 5 4.3 | 4 1.6 | 4 4.8 |
| $\lambda$ (nm) | 8 3.3 | | | | 8 1 0 | 7 9.6 | 7 8 3 | 8 5 0 | 8 5 0 | 8 6 5 | 8 3 3 | 8 3 3 |
| CT D. E | 0.3 | 6.4 | 1.8 | 4.2 | 0.5 | 1.9 | 6.5 | 1.3 | 0.3 | 5.2 | 3.5 | 0.6 |
| (±%) S. E | 0.4 | 5.8 | | | 0.9 | 1.6 | 7.4 | 0.9 | 0.3 | 4.8 | 4.6 | 0.3 |
| CONDITIONS — $\phi$ (°) | 4 5 | | 5 0 | 5 0 | | | | | | | | |
| CONDITIONS — $\lambda$ (nm) | | | | | 8 1 0 | 7 9 6 | 7 8 3 | 8 5 0 | 8 5 0 | 8 6 5 | 8 3 3 | 8 3 3 |
| CONDITIONS — FIELD (Oe) | 3 2 0 | | 4 8 0 | | | | | | | | | |
| CONDITIONS — LATTICE CONSTANT | | | | | | | | | 1 2.4 9 7 ±0.0 0 2Å | | 1 2.5 1 5 ±0.0 0 2Å | |

EP 0 521 527 A2